# EUROPEAN PATENT APPLICATION

(11) **EP 4 628 904 A1**
(43) Date of publication of application: **08.10.2025**
(21) Application number: 23907363.8
(22) Date of filing: 24.10.2023
(51) Int. Cl.: G01R 15/14, G01R 1/20, G01R 19/165, G01R 19/00

(54) **MULTI-PATH CURRENT MEASUREMENT DEVICE**

(30) Priority: 23.12.2022 KR 20220183186
(71) Applicant: LG Energy Solution, Ltd., Seoul 07335 (KR)
(72) Inventor: SEO, Bo Hyun, Daejeon 34122 (KR); LEE, Seung Hyun, Daejeon 34122 (KR); KIM, Tae Youn, Daejeon 34122 (KR); KIM, Kyeong Min, Daejeon 34122 (KR)
(74) Representative: Plasseraud IP
(86) International application number: PCT/KR2023/016552
(87) International publication number: WO 2024/136077

(57) **Abstract**

In the present invention, in order to solve the detection stability problem of the conventional shunt resistor current detector, a path from a shunt resistor to a current calculation processor is branched into a plurality of branch paths and connections between the shunt resistor and respective branch paths connected by a plurality of branch contact points and multiple currents flowing through the shunt resistor is calculated by a processor, so that the stability of current detection is ensured.

## Description

### TECHNICAL FIELD

The present invention relates to a shunt-type current measurement device and current measurement method that measures current using a shunt resistor.

### BACKGROUND ART

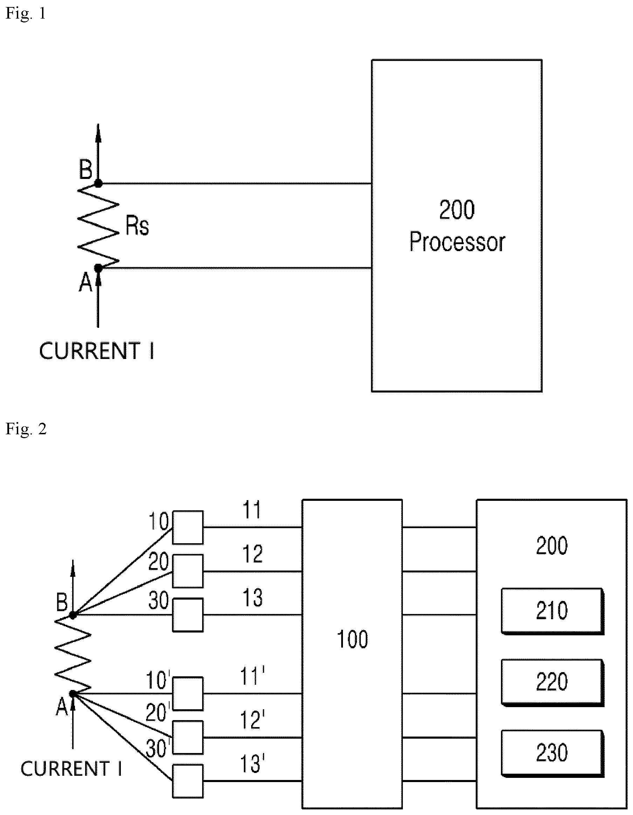

A device that measures a current value flowing through a shunt resistor using the shunt resistor is well known. As shown in FIG. 1, a conventional current measurement device (shunt-type current measurement device) using the shunt resistor measures a shunt resistor voltage from contact points at both ends of a shunt resistor Rs to measure the current flowing in the shunt resistor.

However, such conventional shunt resistance measurement devices/measurement circuits cause a problem in which important current cannot be measured in the BMS when a disconnection or damage to electronic components occurs due to impact. Current measurement is very important in ensuring the safety of driving, especially in the case of electric vehicles, and omission of relevant current measurement information can lead to serious problems directly related to driver safety issues, such as ignition.

Prior art related to this includes the following.
Patent document 1: Korean registered patent No. 10-199801

### DISCLOSURE OF THE INVENTION

### TECHNICAL PROBLEM

Accordingly, an object of the present invention is to solve the problem described above, and provide a current measurement device that enables current measurement through an extra measurement path even when some damage occurs in the current measurement device, further ensures the reliability of current measurement, and can also detect whether or not there is overcurrent.

### TECHNICAL SOLUTION

In order to solve the problem described above, according to an aspect of the present invention, there is provided a current measurement device configured to include a processor that receives outputs of a first and second contact points on both ends of a shunt resistor and calculates a voltage between both ends of the shunt resistor, in which each of the outputs of the first and second contact points is branched into three or more branch paths so that outputs of the branches are respectively input to different input terminals of the processor.

At least one of the three or more branch paths is set as an input path for overcurrent prevention, and at least two branch paths have the same path parameters and provide signals for calculating the same current measurement value.

Meanwhile, the processor of the current measurement device of the present invention includes a current value calculation module that calculates three or more current values from signals received from a plurality of input terminals, an overcurrent detection module that detects overcurrent from at least one current value among the three or more current values, and a current value verification module that compares at least two or more current values among the three or more current values excluding the current value input to the overcurrent detection module, and calculates a selected one of the current values input to the current value verification module as a measured current value.

According to an aspect of the present invention, there is provided a current measurement method including a multiple voltage signal reception step of respectively receiving, by a processor, voltage signals from two or more voltage signal paths branched from one contact point, a multiple shunt current value calculation step of respectively calculating, by the processor, current values flowing through a shunt resistor from the voltage signals respectively received from the two or more voltage signal paths, a shunt current value comparison step of comparing each calculated shunt current value with a predetermined reference range, and a measured current value output step of outputting a shunt current value within the predetermined reference range as a result of the comparison in the shunt current value comparison step as a final measured current value, and further includes an overcurrent determination step of designating any one current value among the current values calculated in the multiple shunt current value calculation step as an overcurrent determination current value, and determining it as an overcurrent when the overcurrent determination current value is greater than or equal to a predetermined reference value.

### ADVANTAGEOUS EFFECTS

According to the present invention, even if some damage occurs in the current measurement device, current measurement is possible through an extra measurement path, thereby ensuring the reliability of current measurement and enabling detection of overcurrent current.

### BRIEF DESCRIPTION OF THE DRAWINGS

The following drawings attached to this specification illustrate preferred embodiments of the present invention, and together with the detailed description of the invention described above serve to further understand the technical idea of the present invention. Therefore, the present invention should not be construed as limited to only the matters described in such drawings.
FIG. 1 is a diagram showing a main configuration of a current measurement device having a single measurement path.
FIG. 2 is a diagram showing a main configuration of a current measurement device having multiple measurement paths.

### MODE FOR CARRYING OUT THE INVENTION

The present invention is based on a current measurement device using a known shunt resistor. The conventional current measurement device forms a voltage measurement path from the first and second contact points on both ends of the shunt resistor and measures a voltage between both ends of the shunt resistor by a processor to calculate a current value flowing through the shunt resistor.

However, in the current measurement device according to the prior art, when the shunt resistor contact point is damaged due to impact or the voltage measurement path is damaged, a problem in which current measurement data is missing occurs.

The present invention provides a current measurement device having the following configuration to solve this problem.

### 1. Current measurement device according to the present invention

### (1) Shunt resistor Rs

A shunt resistor is a resistor with a known resistance value that is provided to measure the current flowing through the shunt resistor by measuring the voltage between both ends thereof.

The shunt resistor has first and second contact points shown as A and B in FIGS. 1 and 2, respectively.

### (2) Voltage measurement paths 11 to 13 and 11' to 13'

The current measurement path is a path connecting the first and second contact points at both ends of the shunt resistor Rs to input terminals of a processor 200, and the processor 200 receives voltage values at both ends of the shunt resistor therefrom.

FIG. 1 shows a case where voltage measurement paths are formed as a pair, and FIG. 2 shows a case where voltage measurement paths 11 to 13 and 11' to 13' are formed by branching into three branch path pairs. In this case, the present invention has three pairs of branch contact points 10, 20, 30, 10', 20', 30' connected to the first and second contact points of the shunt resistor, respectively.

FIG. 2 shows that each of the first and second contact points branches into three branch paths, but the present invention can be configured to have three or more branch paths.

### (3) Voltage sensing circuit 100

The voltage sensing circuit 100 may be connected to the voltage measurement path of the present invention. The voltage sensing circuit 100 is disposed between the branch contact points and the input terminals of the processor, an input stage thereof is connected to the branch contact points and an output stage thereof is connected to the input terminals of the processor. The voltage sensing circuit 100 senses a voltage between both ends of the shunt resistor and provides the voltage to the input terminals of the processor, configures path parameters for each branch path by including a sensing resistor (not shown), a sensing capacitor (not shown), a signal amplifying element, and an ADC, and sense the voltage between both ends of the shunt resistor.

The path parameters include a sensing resistance value and a sensing capacitance on the path. Among the three or more branch paths of the present invention, at least two branch paths have the same path parameters (sensing resistance value and sensing capacitance) and theoretically transmit signals to the processor so as to measure the same voltage value. Path parameters of at least one path are set so that the output value can be compared in magnitude with a predetermined overcurrent reference current value so that it can be applied to overcurrent detection. For at least one path, path parameters are set so that a magnitude relationship with a predetermined overcurrent reference current value can be compared so that an output value thereof is applied to overcurrent detection. The final output stage on each path of the voltage sensing circuit 100 may include the ADC.

### (4) Processor 200

At the end point of the voltage measurement path of the present invention, a processor having a plurality of input terminals that receive input from respective branch paths is configured. At the rear of the input stage and inside the processor, an ADC circuit may be included if it is not provided in the voltage sensing circuit.

The processor 200 may include a current calculation module (not shown), an overcurrent detection module (not shown), and a current value verification module (not shown). Each module described below is defined as a group of software algorithms installed on the processor, and calculates the output of each algorithm based on the signals received at each input stage.

### ① Current value calculation module 210

The current value calculation module calculates a value of the voltage between both ends of the shunt resistor input from the multiple paths received through the input terminals and combines the known shunt resistor value and the path parameter values described above to calculate the current value for each path flowing through the shunt resistor.

The voltage value may be calculated differently depending on the path parameter values for each branch path, but the path parameter values for at least two branch paths are set to be the same so that, if there is no failure, the same current value is calculated. Accordingly, at least two current calculation values should theoretically have the same value.

Meanwhile, at least one current calculation value is a current value for overcurrent detection calculated from a combination of path parameter values and shunt resistor values set so that the magnitude relationship with the predetermined overcurrent reference current value described above can be compared.

### ② Current value verification module 220

The current value verification module compares at least two current values that should theoretically be calculated to be the same described above, selects a current value without an error if the error is greater than a predetermined reference value, and calculates the current value as a final current measurement value. Through this, for example, if one branch path is damaged and current is not detected, the current value calculated from an undamaged branch path can be calculated as the final current measurement value.

The current value verification module can additionally perform current value verification by taking data of a predetermined maximum current value and minimum current value and further comparing it with the compared and selected current value in order to select an error-free current value. If the selected current value is greater than the predetermined maximum current value or less than the predetermined minimum current value, an error in the entire current detection device in which correct current calculation is not performed can be detected.

### ③ Overcurrent detection module 230

The overcurrent detection module compares the at least one overcurrent detection current value with a predetermined overcurrent reference current value and detects whether or not the current flowing through the shunt resistor is overcurrent.

### 2. Current measurement method according to the present invention

A procedure for measuring current using the current measurement device of the present invention described above will be described.

First, a multi-path that constitutes a voltage signal path branching from the contact points of the shunt resistor on the current path into two or more paths to the current calculation processor is configured.

Next, the processor receives a multi-voltage signal that receives a voltage signal from each of the two or more voltage signal paths. Thereafter, the processor performs a multiple shunt current value calculation step of calculating the current value flowing through the shunt resistor from each voltage signal received from the two or more voltage signal paths. In this case, the path parameters of the two or more voltage signal paths are set to be the same so as to output theoretically the same voltage signal.

The processor performs a shunt current value comparison step of comparing each calculated shunt current value with a predetermined reference range, and outputs a shunt current value within a predetermined reference range as the final measured current value as a result of the comparison in the shunt current value comparison step.

Meanwhile, the multi-path may consist of three or more multi-paths. In this case, an overcurrent determination step of designating any one current value among the current values calculated in the multiple shunt current value calculation step as an overcurrent determination current value, and determining it as an overcurrent when the overcurrent determination current value is greater than or equal to a predetermined reference value.

The followings are the signs and names of the elements used in the drawings and description of the present invention.
- 100: Voltage sensing circuit
- 200: Processor
- 10, 20, 30, 10', 20', 30': Branch contact points
- 210: Current value calculation module
- 220: Current value verification module
- 230: Overcurrent detection module

## Claims

1. A current measurement device comprising:
first and second contact points on both ends of a shunt resistor; and
a processor that receives outputs of the first and second contact points and calculates a voltage between both ends of the shunt resistor, wherein
each of the outputs of the first and second contact points is branched into three or more branch paths so that outputs of the branches are respectively input to different input terminals of the processor.

2. The current measurement device of claim **1,** wherein
at least one of the three or more branch paths is set as an input path for overcurrent prevention.

3. The current measurement device of claim **1,** wherein
at least two of the three or more branch paths have the same path parameters, and the processor
verifies a validity of the measured values by comparing the measured values through the at least two branch paths having the same path parameters.

4. A current measurement device comprising:
a shunt resistor disposed on a current path;
first and second contact points on both ends of the shunt resistor;
a pair of branch paths whose one ends are connected to the first and second contact points and the other ends are respectively branch into three or more paths;
branch contact points to which the branched other ends of the branch paths are respectively connected; and
a processor including a plurality of input terminals that respectively receive outputs of the branch contact points.

5. The current measurement device of claim 4, wherein
the processor comprises
a current value calculation module that calculates three or more current values from signals received from the plurality of input terminals,
an overcurrent detection module that detects overcurrent from at least one current value among the three or more current values, and
a current value verification module that compares at least two or more current values among the three or more current values excluding the current value input to the overcurrent detection module, and
calculates a selected one of the current values input to the current value verification module as a measured current value.

6. The current measurement device of claim 5, further comprising:
a voltage sensing circuit which is disposed between the branch contact points and the input terminals of the processor, whose input stage is connected to the branch contact points, whose output stage is connected to the input terminals of the processor, and which senses a voltage between both ends of the shunt resistor and provides the voltage to the input terminals of the processor.

7. The current measurement device of claim 6,
respective paths of the voltage sensing circuit comprise a sensing resistor and a sensing capacitor to determine path parameters of respective paths.

8. The current measurement device of claim 6,
at least two of the paths are set to have the same path parameters.

9. A current measurement method comprising:
a multiple voltage signal reception step of respectively receiving, by a processor, voltage signals from two or more voltage signal paths branched from one contact point;
a multiple shunt current value calculation step of respectively calculating, by the processor, current values flowing through a shunt resistor from the voltage signals respectively received from the two or more voltage signal paths;
a shunt current value comparison step of comparing each calculated shunt current value with a predetermined reference range; and
a measured current value output step of outputting a shunt current value within the predetermined reference range as a result of the comparison in the shunt current value comparison step as a final measured current value.

10. A current measurement method of claim 9, further comprising:
an overcurrent determination step of designating any one current value among the current values calculated in the multiple shunt current value calculation step as an overcurrent determination current value, and determining it as an overcurrent when the overcurrent determination current value is greater than or equal to a predetermined reference value.
